# EUROPEAN PATENT APPLICATION

(11) **EP 2 863 508 A1**
(43) Date of publication of application: **22.04.2015**
(21) Application number: 13806236.9
(22) Date of filing: 06.06.2013
(51) Int. Cl.: H02H 7/10, G01R 19/165, G01R 25/00

(54) **PROTECTIVE CIRCUIT FOR HIGH FREQUENCY HEATING DEVICE AND HIGH FREQUENCY HEATING DEVICE HAVING SAME**

(30) Priority: 18.06.2012 CN 201220288230 U
(71) Applicant: Midea Group Co., Ltd., Guangdong 528311 (CN); GUANGDONG MIDEA KITCHEN APPLIANCES MANUFACTURING CO., LTD., Shunde Foshan Guangdong 528311 (CN)
(72) Inventor: HUANG, Bin, Foshan Guangdong 528311 (CN); ZHENG, Nianzhong, Foshan Guangdong 528311 (CN); CHEN, Xingchao, Foshan Guangdong 528311 (CN)
(74) Representative: advotec.
(86) International application number: PCT/CN2013/076851
(87) International publication number: WO 2013/189242

(57) **Abstract**

A protective circuit for a high frequency heating device and a high frequency heating device having same, the protective circuit for a high frequency heating device comprising: an input winding (1), a sampling winding (2), a phase comparison module (3), a voltage comparison module (4), and a controller (5); the input winding (1) is connected to the switching device of the high frequency heating device; the sampling winding (2) is disposed relative to the input winding (1) and is used to sample a voltage signal on the switching device; the phase comparison module (3) and the voltage comparison module (4) are respectively connected to the sampling winding (2); the phase comparison module (3) outputs a first comparison signal according to a voltage phase signal in the voltage signals; the voltage comparison module (4) outputs a second comparison signal according to the comparison between the voltage amplitude of the voltage signal and a preset reference voltage; the controller (5) controls the switching device to synchronously switch on and off according to the first comparison signal, and protects the switching device according to the second comparison signal. The protective circuit for a high frequency heating device improves the circuit reliability of the high frequency heating device, and reduces accumulated error caused by a plurality of resistors connected in series, thus saving cost.

## Description

### FIELD

The present invention relates to a field of high frequency heating devices, and more particularly to a protective circuit for a high frequency heating device and a high frequency heating device having the same.

### BACKGROUND

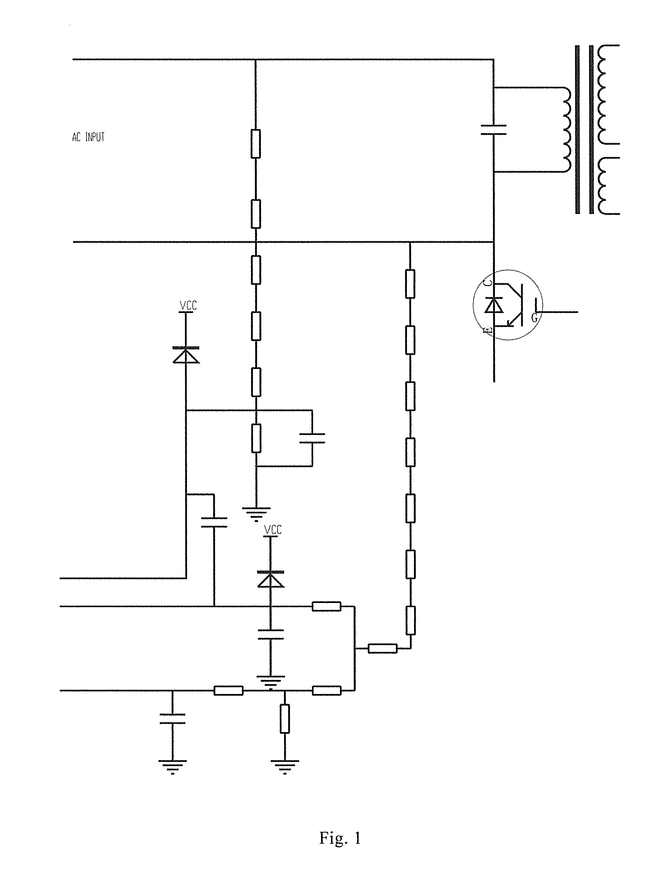

As for the power source of a high frequency heating device such as an electromagnetic oven or an inverter microwave oven, in order to protect a switching element and determine the on/off time of the switching element, a voltage and a phase thereof on the switching element need to be detected and compared, so as to trigger the protection mechanism. Conventionally, as shown in Fig. 1, the detection is performed at a point to be detected in the circuit, and then the voltage is divided by resistors to obtain a comparison signal.

Since the voltage is rather high, approximately 1000 volts, there must be many elements in the circuit to be detected, which increases the cost but reduces reliability.

### SUMMARY

The present invention seeks to solve at least one of the above technical problems.

Therefore, an objective of the present invention is to provide a practical and reliable protective circuit for a high frequency heating device with a simple structure and low cost, so as to overcome the defects in the related art.

To achieve the objective, embodiments of the present invention provide a protective circuit for a high frequency heating device. The circuit includes an input winding connected with a switching element of the high frequency heating device; a sampling winding arranged corresponding to the input winding, and configured to sample a voltage signal on the switching element; a phase comparison module and a voltage comparison module connected with the sampling winding respectively, in which the phase comparison module outputs a first comparison signal according to a voltage phase signal in the voltage signal, and the voltage comparison module outputs a second comparison signal according to a comparison between a voltage amplitude of the voltage signal and a preset reference voltage; a controller connected with the phase comparison module, the voltage comparison module and the switching element, and configured to control the switching element to switch on and off synchronously according to the first comparison signal, and to protect the switching element according to the second comparison signal.

With the protective circuit according to embodiments of the present invention, the problem that a plurality of resistors are connected in series in the voltage division method can be avoided, sparing many voltage division resistors, which improves reliability of the circuit, reduces accumulated error resulted from a plurality of resistors connected in series, and saves the cost. Moreover, the induced voltage on the sampling winding corresponds to the voltage of the input winding, so it is attainable to control the switching element to switch on and off synchronously and protect the switching element under an overvoltage or under-voltage situation by the voltage phase and amplitude on the sampling winding.

In an embodiment of the present invention, the second comparison signal includes an overvoltage protection trigger signal and an under-voltage protection trigger signal.

Preferably, in an embodiment of the present invention, the protective circuit further includes a rectifying module connected with the sampling winding and configured to receive an output signal from the sampling winding for supplying power, in which the rectifying module may be a half-wave rectifying circuit or a full-bridge rectifying circuit.

Therefore, the protective circuit according to embodiments of the present invention can provide an auxiliary power source to reduce the cost, volume and power consumption of a power supply part of a control circuit.

Specifically, in an embodiment of the present invention, the phase comparison module includes a first resistor and a first capacitor connected in series, in which the first resistor defines a first terminal connected with a first terminal of the sampling winding and a second terminal connected with a first terminal of the first capacitor, a second terminal of the first capacitor is grounded, and the first resistor and the first capacitor have a first node therebetween; a second resistor connected with the first capacitor in parallel, and defining a first terminal connected with the first node and a second terminal grounded; a first diode defining an anode grounded and a cathode connected with the first node; and a first comparator defining an in-phase input terminal connected with the first node, a reverse-phase input terminal connected with a second terminal of the sampling winding, and an output terminal connected with the controller.

The voltage comparison module includes a second comparator defining an in-phase input terminal connected with the first node, a reverse-phase input terminal connected with the preset reference voltage, and an output terminal connected with the controller.

Preferably, in an embodiment of the present invention, the switching element may be an insulated gate bipolar transistor (IGBT).

In some embodiments of the present invention, the high frequency heating device may be an electromagnetic oven or an inverter microwave oven, in which the sampling winding is a secondary winding with a preset number of coil turns on a main transformer of the inverter microwave oven or a ferrite of the electromagnetic oven.

In an example of the present invention, the preset number may be 1 to 3.

In addition, the present invention further provides a high frequency heating device including the above protective circuit.

Additional aspects and advantages of the present invention will be given in part in the following descriptions, become apparent in part from the following descriptions, or be learned from the practice of the embodiments of the present invention.

### BRIEF DESCRIPTION OF THE DRAWINGS

These and/or additional aspects and advantages of the present invention will become apparent and more readily appreciated from the following descriptions made with reference to the drawings, in which:
Fig. 1 is a schematic diagram of a synchronous protective circuit and an IGBT overvoltage protective circuit in the related art; and
Fig. 2 is a schematic diagram of a protective circuit for a high frequency heating device according to an embodiment of the present invention.

### Reference numerals:

- 1: input winding
- 2: sampling winding
- 3: phase comparison module
- 4: voltage comparison module
- 5: controller
- 6: rectifying module
- R1: first resistor
- C1: first capacitor
- R2: second resistor
- D1: first diode
- IC1: first comparator
- IC2: second comparator
- 7: primary winding
- 8: secondary winding

### DETAILED DESCRIPTION

Embodiments of the present invention will be described in detail and examples of the embodiments will be illustrated in the drawings, where same or similar reference numerals are used to indicate same or similar members or members with same or similar functions. The embodiments described herein with reference to the drawings are explanatory, which are used to illustrate the present invention, but shall not be construed to limit the present invention.

Various embodiments and examples are provided in the following description to implement different structures of the present invention. In order to simplify the present invention, certain elements and settings will be described. However, these elements and settings are only by way of example and are not intended to limit the present invention. In addition, reference numerals may be repeated in different examples in the present invention. This repeating is for the purpose of simplification and clarity and does not refer to relations between different embodiments and/or settings. Furthermore, examples of different processes and materials are provided in the present invention, but it would be appreciated by those skilled in the art that other processes and/or materials may be also applied. Moreover, a structure in which a first feature is "on" a second feature may include an embodiment in which the first feature directly contacts the second feature, and may also include an embodiment in which an additional feature is formed between the first feature and the second feature so that the first feature does not directly contact the second feature.

In the description of the present invention, it should be understood that, unless specified or limited otherwise, the terms "mounted," "connected," and "coupled" and variations thereof are used broadly, and may be, for example, mechanical or electrical connections; may also be inner communications or interaction of two elements; may be direct connections; may also be indirect connections via intervening structures, which can be understood by those skilled in the art according to specific situations.

Referring to the following descriptions and drawings, these and other aspects of the embodiments of the present invention will be apparent. In these descriptions and drawings, some specific approaches of the embodiments of the present invention are provided, so as to show some ways to perform the principle of the embodiments of the present invention, however it should be understood that the embodiment of the present invention is not limited thereby. Instead, the embodiments of the present invention comprise all the variants, modifications and their equivalents within the spirit and scope of the present invention as defined by the claims.

In the following, a protective circuit for a high frequency heating device and a high frequency heating device with the same according to the embodiments of the present invention will be described with respect to the drawings.

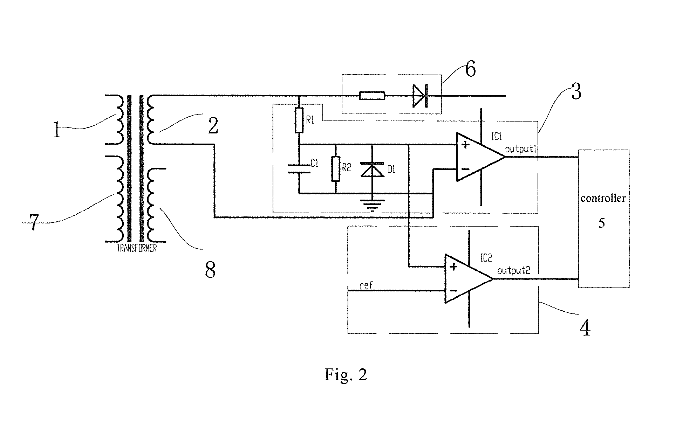

Fig. 2 is a schematic diagram of a protective circuit for a high frequency heating device according to an embodiment of the present invention. In the embodiment, the high frequency heating device is an inverter microwave oven. As shown in Fig. 2, the protective circuit includes an input winding 1, a sampling winding 2, a phase comparison module 3, a voltage comparison module 4 and a controller 5.

The input winding 1 is connected with a switching element of the high frequency heating device, and the sampling winding 2 is arranged corresponding to the input winding 1 and configured to sample a voltage signal on the switching element. The phase comparison module 3 and the voltage comparison module 4 are connected with the sampling winding 2 respectively, in which the phase comparison module 3 outputs a first comparison signal according to a voltage phase signal in the voltage signal, and the voltage comparison module 4 outputs a second comparison signal according to a comparison between a voltage amplitude of the voltage signal and a preset reference voltage. The controller 5 is connected with the phase comparison module 3, the voltage comparison module 4 and the switching element (not shown), and configured to control the switching element to switch on and off synchronously according to the first comparison signal and to protect the switching element according to the second comparison signal.

In an embodiment of the present invention, the second comparison signal includes an overvoltage protection trigger signal and an under-voltage protection trigger signal.

In embodiments of the present invention, the voltage signal on the switching element is coupled out through the sampling winding 2 on a main transformer of the high frequency heating device; a voltage phase and a voltage amplitude of the switching element in a main circuit of the high frequency heating device are mapped accurately; and an output signal is transmitted via the sampling winding 2 to the voltage comparison module 4 and the phase comparison module. The output signal from the sampling winding 2 is compared with the output signal from the phase comparison module 3, so as to realize phase comparison. The output signal from the sampling winding 2 is compared with the preset reference voltage by the voltage comparison module 4, so as to output an overvoltage or under-voltage protection trigger signal to the controller 5. The preset reference voltage is represented by "ref" as shown in Fig. 2, which may be a software set value or a hardware circuit set value set in advance.

Preferably, in an embodiment of the present invention, as shown in Fig. 2, the protective circuit further includes a rectifying module 6. The rectifying module 6 is connected with the sampling winding 2 and configured to receive the output signal from the sampling winding 2 for supplying power, in which the rectifying module may be a half-wave rectifying circuit or a full-bridge rectifying circuit.

It can be known that the protective circuit can provide an auxiliary power source to reduce the cost, volume and power consumption of a power supply part of a control circuit.

Specifically, in an embodiment of the present invention, as shown in Fig. 2, the phase comparison module 3 includes a first resistor R1, a first capacitor C1, a second resistor R2, a first diode D1 and a first comparator IC1. The first resistor R1 and the first capacitor C1 are connected in series, in which the first resistor R1 has a first terminal connected with a first terminal of the sampling winding 2 and a second terminal connected with a first terminal of the first capacitor C1; a second terminal of the first capacitor C1 is grounded; and the first resistor R1 and the first capacitor C1 have a first node A therebetween. The second resistor R2 is connected with the first capacitor C1 in parallel, and has a first terminal connected with the first node A and a second terminal grounded. The first diode D1 has an anode grounded and a cathode connected with the first node A. The first comparator IC1 has an in-phase input terminal connected with the first node A, a reverse-phase input terminal connected with a second terminal of the sampling winding 2, and an output terminal connected with the controller 5.

As shown in Fig. 2, the voltage comparison module 4 includes a second comparator IC2. The second comparator IC2 has an in-phase input terminal connected with the first node A, a reverse-phase input terminal connected with the preset reference voltage ref, and an output terminal connected with the controller 5.

It should be noted that the circuit type of the phase comparison module 3, the voltage comparison module 4 and the rectifying module 6 is not limited to the circuit shown in Fig. 2.

In addition, as shown in Fig. 2, the protective circuit further includes a primary winding 7 and a corresponding secondary winding 8.

In a preferable embodiment of the present invention, the switching element may be an insulated gate bipolar transistor (IGBT).

Therefore, in embodiments of the present invention, the voltage signal on the switching element is coupled out through the sampling winding 2 on the main transformer of the high frequency heating device; the voltage phase and the voltage amplitude of the switching element in the main circuit of the high frequency heating device are mapped accurately; and the signal is used in a comparison circuit. The main transformer is wound with 1 to 2 turns of coil as the sampling winding. By detecting an induced voltage phase on the sampling winding, the IGBT in the main circuit can be switched on and off synchronously, and by detecting an induced voltage on the sampling winding, the IGBT can be protected under an overvoltage or under-voltage situation. Meanwhile, an auxiliary power source is provided to reduce the cost, volume and power consumption of the power supply part of the control circuit. First, the overvoltage protection of the switching element can be performed; second, the on-off time of the switching element can be determined; third, the sampling winding can be used as a power source for auxiliary power supply for the control circuit.

In other embodiments of the present invention, the high frequency heating device can be the inverter microwave oven or the electromagnetic oven mentioned above. The sampling winding 2 is a secondary winding with a preset number of coil turns on the main transformer of the inverter microwave oven or a ferrite of the electromagnetic oven. In one example, the preset number is 1 to 3. It should be noted that the sampling winding 2 can be formed by winding several turns of coil on the ferrite underlying a furnace plate, since the electromagnetic oven has no main transformer.

In addition, the present invention further provides a high frequency heating device which includes the above protective circuit.

Reference throughout this specification to "an embodiment," "some embodiments," "examples," "specific examples," or "some examples" means that a particular feature, structure, material, or characteristic described in connection with the embodiment or example is included in at least one embodiment or example of the present invention. Thus, these terms throughout this specification do not necessarily refer to the same embodiment or example of the present invention. Furthermore, the particular features, structures, materials, or characteristics may be combined in any suitable manner in one or more embodiments or examples.

Although embodiments of the present invention have been shown and described, it would be appreciated by those skilled in the art that changes, modifications, alternatives and variations can be made in the embodiments without departing from the scope of the present invention. The scope of the present invention is defined by the claims and the like.

## Claims

1. A protective circuit for a high frequency heating device, comprising:
an input winding connected with a switching element of the high frequency heating device;
a sampling winding arranged corresponding to the input winding, and
configured to sample a voltage signal on the switching element;
a phase comparison module and a voltage comparison module connected with the sampling winding respectively, wherein the phase comparison module outputs a first comparison signal according to a voltage phase signal in the voltage signal, and the voltage comparison module outputs a second comparison signal according to a comparison between a voltage amplitude of the voltage signal and a preset reference voltage; and
a controller connected with the phase comparison module, the voltage comparison module and the switching element, and configured to control the switching element to switch on and off synchronously according to the first comparison signal, and to protect the switching element according to the second comparison signal.

2. The protective circuit according to claim 1, wherein the second comparison signal comprises an overvoltage protection trigger signal and an under-voltage protection trigger signal.

3. The protective circuit according to claim 1, further comprising:
a rectifying module connected with the sampling winding and configured to receive an output signal from the sampling winding for supplying power.

4. The protective circuit according to claim 3, wherein the rectifying module is a half-wave rectifying circuit or a full-bridge rectifying circuit.

5. The protective circuit according to claim 1, wherein the phase comparison module comprises:
a first resistor and a first capacitor connected in series, the first resistor defining a first terminal connected with a first terminal of the sampling winding and a second terminal connected with a first terminal of the first capacitor, a second terminal of the first capacitor being grounded, the first resistor and the first capacitor having a first node therebetween;
a second resistor connected with the first capacitor in parallel, and defining a first terminal connected with the first node and a second terminal grounded;
a first diode defining an anode grounded and a cathode connected with the first node; and
a first comparator defining an in-phase input terminal connected with the first node, a reverse-phase input terminal connected with a second terminal of the sampling winding, and an output terminal connected with the controller.

6. The protective circuit according to claim 5, wherein the voltage comparison module comprises:
a second comparator defining an in-phase input terminal connected with the first node, a reverse-phase input terminal connected with the preset reference voltage, and an output terminal connected with the controller.

7. The protective circuit according to any one of claims 1-6, wherein the switching element is an insulated gate bipolar transistor IGBT.

8. The protective circuit according to any one of claims 1-7, wherein the high frequency heating device is an electromagnetic oven or an inverter microwave oven.

9. The protective circuit according to claim 8, wherein the sampling winding is a secondary winding with a preset number of coil turns on a main transformer of the inverter microwave oven or a ferrite of the electromagnetic oven.

10. The protective circuit according to claim 9, wherein the preset number may be 1 to 3.

11. A high frequency heating device comprising a protective circuit according to any one of claims 1-10.
